# EUROPEAN PATENT SPECIFICATION

(11) **EP 3 500 906 B1**
(45) Date of publication and mention of the grant of the patent: **27.03.2024**
(21) Application number: 17841146.8
(22) Date of filing: 16.08.2017
(51) Int. Cl.: G06F 1/16, A45C 11/00, G06F 15/02, A45C 13/10, H04M 1/02, H04M 1/04, H04M 1/18, H05B 45/20, H05B 45/24

(54) **PROTECTIVE CASE**
SCHUTZGEHÄUSE
ÉTUI DE PROTECTION

(30) Priority: 16.08.2016 US 201662375745 P
(43) Date of publication of application: 26.06.2019
(73) Proprietor: Rakuten Group, Inc., Setagaya-ku Tokyo 158-0094 (JP)
(72) Inventor: BUECHIN, Anna, Toronto, ON M6J 1S1 (CA)
(74) Representative: EIP
(86) International application number: PCT/IB2017/001175
(87) International publication number: WO 2018/033796

(56) References cited:
- JP-U- 3 199 016
- JP-U- 3 204 680
- US-A1- 2014 205 799
- US-A1- 2015 222 736
- US-A1- 2015 222 736
- US-A1- 2015 296 946
- US-B1- 8 807 333
- US-B1- 9 049 911

## Description

### BACKGROUND

The "background" description provided herein is for the purpose of generally presenting the context of the disclosure. Work of the presently named inventors, to the extent it is described in this background section, as well as aspects of the description which may not otherwise qualify as prior art at the time of filing, are neither expressly or impliedly admitted as prior art against the present invention.

Mobile computing devices, such as laptops, PDAs, media players, game consoles, touchpads, smartphones, e-readers etc., have evolved to become more and more sophisticated. With the rapidly developing technologies on Internet data storage, data transmission, and wireless communication as well as on data-handling capabilities of mobile computing devices, consumers increasingly spend extended time using such devices, such as watching videos, viewing photos, video conferencing, reading books, Internet browsing, sending emails, on-line chatting, playing video games, etc. To suit consumers' demand for portability, the design trend of various mobile computing devices continues to emphasize making the devices smaller and thinner. Most modern portable computing devices are installed with a touchscreen panel that is fixed to the device body. To view the display screen hands-free in an ergonomic view angle to reduce related visual discomforts, a user usually needs to position the device in an inclined angle (or an upright position) on a horizontal resting surface, e.g., a desk. Most mobile computing device products are not equipped with a built-in stand for supporting the device in an upright position. External accessories of various configurations are typically used to prop such a device in a user-intended orientation. In some of the accessory products, a stand is integrated with a protective case customized for a device model; while others are designed exclusively as a stand.
US 8 807 333 B1 discloses a tablet case comprising a cover and a plurality of metal plates and magnets for securing the different positions of the cover.
US 2015/222736 A1 discloses a celluar phone case with a hall IC driving shielding magnet and a yoke having specific structures in the cellular phone case to increase user convenience.
US 2015/296946 A1 discloses a housing accessory comprising a foldable cover member that has an upper portion, a flap portion, and a single folding hinge between the two portions and extending diagonally across the foldable cover, the housing accessory being convertible to a stand for a mobile computing device. US9049911 B1 discloses a cover for an electronic device including a back cover, such as a tray, to receive the electronic device. The cover may also include a foldable flap that is foldable into a stand to support an electronic device held by the cover at one or more viewing angles oblique to a surface on which the cover is placed. The back cover and/or the foldable flap may include one or more activation mechanisms that, when moved relative to the electronic device, activate one or more functions of the electronic device (e.g., camera functions, display of information, etc.).

### SUMMARY

The foregoing paragraphs have been provided by way of general introduction, and are not intended to limit the scope of the following claims. The described embodiments, together with further advantages, will be best understood by reference to the following detailed description taken in conjunction with the accompanying drawings.

According to aspects of the invention, a protective case is provided in accordance with claim 1.

### BRIEF DESCRIPTION OF THE DRAWINGS

A more complete appreciation of the invention and many of the attendant advantages thereof will be readily obtained as the same becomes better understood by reference to the following detailed description when considered in connection with the accompanying drawings, wherein:
Fig. 1 depicts an exemplary overview of a protective case according to an embodiment;
Fig. 2 depicts an exemplary overview of an electronic reading device with a protective case according to an embodiment;
Fig. 3A depicts a front view of a protective case in a closed position according to an embodiment;
Fig. 3B depicts a perspective view of a protective case in a closed position according to an embodiment;
Fig. 4A depicts a front view of a protective case with a portion of the protective case folded behind an electronic reading device according to an embodiment;
Fig. 4B depicts a perspective view of back of an electronic reading device with a portion of a protective case folded behind the electronic reading device according to an embodiment;
Fig. 5A depicts a perspective view of a protective case in a stand position according to an embodiment; and
Fig. 5B depicts a rear view of a protective case in a stand position according to an embodiment.

### DETAILED DESCRIPTION

The description set forth below in connection with the appended drawings is intended as a description of various embodiments of the disclosed invention and is not necessarily intended to represent the only embodiment(s). In certain instances, the description includes specific details for the purpose of providing an understanding of the disclosed invention. However, it will be apparent to those skilled in the art that embodiments may be practiced without these specific details. In some instances, well-known structures and components may be shown in block diagram form in order to avoid obscuring the concepts of the disclosed invention.

Reference throughout the specification to "one embodiment" or "an embodiment" means that a particular feature, structure, characteristic, operation, or function described in connection with an embodiment is included in at least one embodiment of the disclosed subject matter. Thus, any appearance of the phrases "in one embodiment" or "in an embodiment" in the specification is not necessarily referring to the same embodiment. Further, the particular features, structures, characteristics, operations, or functions may be combined in any suitable manner in one or more embodiments. Further, it is intended that embodiments of the disclosed subject matter can and do cover modifications and variations of the described embodiments.

Referring now to the drawings, wherein like reference numerals designate identical or corresponding parts throughout the several views.

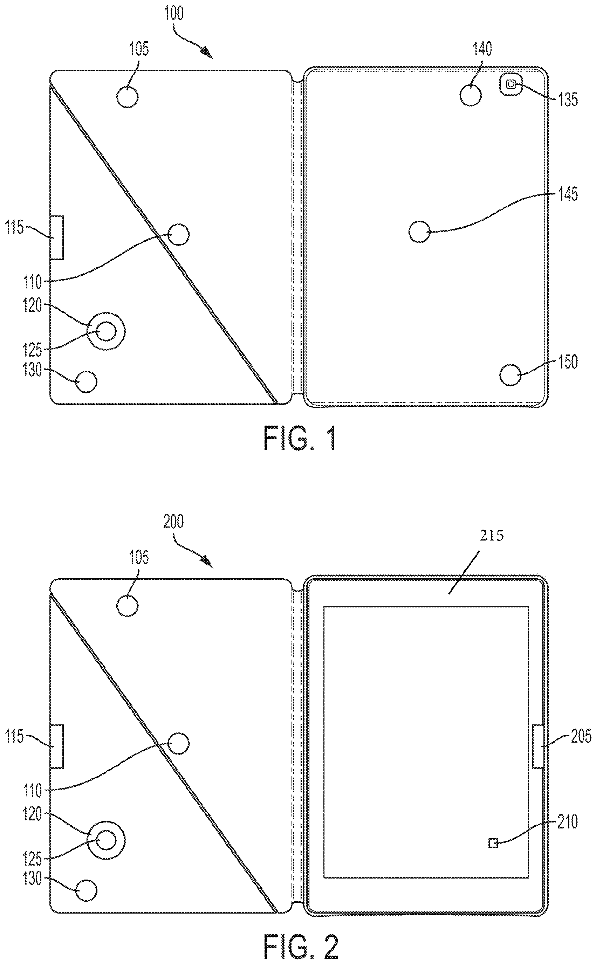

Fig. 1 depicts an exemplary overview of a protective case 100 according to an embodiment. The protective case 100 can be configured to employ a one-fold stand structure on a foldable hard cover designed as an accessory for a mobile computing device (e.g., electronic reading device). The foldable hard cover may serve as a front cover, for example, to protect the display screen of the computing device in a covered position and as a stand in open display position. The foldable cover includes an upper portion, a flap portion, and a single folding hinge between the two portions and extending diagonally across the foldable cover. The flap portion can be rotated about the single holding hinge between a coplanar position with the upper portion and a folded position. Being folded twice, the foldable cover can be converted into a display stand operable to retain the device in an inclined angle on a supporting surface, thus providing a comfortable view angle to a device user. The flap portion may be the lower portion of the front cover or an extra layer coupled to the front cover at the single folding hinge. Further, the foldable front cover may be coupled to a back cover through a hinge spine. The back cover may be non-foldable or alternatively have the same folding configuration and thus can fold in unison with the front cover into a stand.

Overall, provided herein is a mobile computing device protective case with at least one foldable cover having an angled folding hinge around which a flap member of the foldable cover can rotate to a folded position. Thereby, the foldable cover is converted to a stand operable to support the mobile computing device at an inclined angle with reference to a supporting surface.

In an embodiment, an exemplary protective case has a diagonal folding hinge on the front cover and operable to protect an electronic reading device as well as support it in an upright position in accordance with an embodiment of the present invention.

The protective case can include a front cover and a back cover that are rotatably coupled together through a hinge spine. The electronic reading device can be detachably affixed (snapped in) and secured to the back cover, for example. The front cover can have a single folding hinge that divides the front cover into an upper portion next to the hinge spine and a lower portion.

The folding hinge of the cover runs approximately diagonally across the front cover and terminates near two opposite edges of the rectangular front cover. The lower portion can have an edge that coincides with a long edge of the front cover, and another edge that coincides with a substantial portion of a short edge of the front cover.

When the electronic reading device is not in use, the two portions of the front cover can be coplanar and can advantageously cover the entire display screen (the front side) of the electronic reading device to protect it from external damage. Also, the back cover can be used to protect the back side of the electronic reading device.

When the electronic reading device is in use, and particularly with the display screen on, the front cover can be rotated around the hinge spine to an open display position to uncover the display screen. If a user intends to retain the electronic reading device in an upright position hands-free, the front cover can be rotated further towards the back side of the electronic reading device (e.g., folded behind the electronic reading device), and the lower portion can be rotated relative to the upper portion around the folding hinge to a folded position. That is, subject to a single fold, the front cover is converted into a sturdy supporting stand. The lower portion at the folded position has only the edge directly contacting the supporting surface. As a result, the electronic reading device can advantageously rest on the external supporting surface in an inclined angle.

The front cover with the lower portion in a single folded position can uprightly support the electronic reading device in both portrait and landscape orientations. The lower portion and the upper portion form an angle of 130° at the instant folded position, for example. Without changing the folded position of the lower portion relative to the upper portion, the front cover can support the tablet in an upright position in both a portrait view mode and a landscape view mode. That is, a user can change a view orientation of the electronic reading device without readjusting the folding angle of the front cover. However in some other embodiments, a portrait view mode and a landscape view mode may require the front cover be folded in different angles to achieve stability.

The protective case and the associated components may be manufactured by any suitable processes and materials that are well known in the art. The back cover may primarily have a rigid and non-foldable panel. In an embodiment, magnets are installed (e.g., embedded) in the front cover such that the upper portion can be conformal to the back cover by force of the magnets.

At the folded position, the upper portion and the lower portion can form an angle of 130°, for example, which can also be the stop position for the lower portion. A continuous range of stable view angles may be achieved as a user adjusts the lower portion between the position coplanar with the upper portion and the stop position. It will be appreciated that the stop position, or the rotation limit of the lower portion, is dependent on the configuration of the foldable cover. During the product design for a protective case according to the present invention, a stop position can be determined by factoring in the weight and dimension of the mobile computing device, the geometry, location and orientation of the folding hinge, the materials used to manufacture the front cover and the back cover, the range of inclined angles to be achieved, and etc.

The protective case may be made of soft materials (for exterior and interior surfaces) covering one or more rigid panels or reinforcement structures. The soft materials may include one or more of polyurethane (PU) laminate, neoprene, silicone, microfiber cloth, leather, rubber, vinyl, polyvinyl chloride (PVC), plastic, etc. The reinforcement structure may include one or more of stiff polycarbonate (PC) or other plastic, wood, metal, etc.

The folding hinge area may include only the soft materials and lack a reinforcement structure. In an embodiment, the upper portion and the lower portion of a front cover may have different materials in their respective reinforcement structures, for instance an EVA foam sheet for the lower portion and polycarbonate for the upper portion.

It will be appreciated that the configuration of a convertible protective case can be customized for a single or multiple mobile device models. A protective case can be designed for any type of mobile electronic device, such as tablet computer, touchpad, smartphone, e-reader, laptop, GPS, PDA, and etc.

The protective case 100 can include a first stand magnet 105, a second stand magnet 110, a closing magnet 115, a magnet shielding 120, a Hall sensor magnet 125, a flap magnet 130, a button cover 135 (e.g., the button cover 135 can be integrated into the back cover of the protective case 100 and be configured to cover a power/sleep button integrated into the electronic reading device), a first metal plate 140, a second metal plate 145, and a flap metal plate 150. More specifically, a front cover of the protective case 100 (wherein the front cover corresponds to a left side of the protective case 100 as depicted in Fig. 1) can include the first stand magnet 105, the second stand magnet 110, the closing magnet 115, the magnet shielding 120, the Hall sensor magnet 125, and the flap magnet 130. Additionally, a back cover of the protective case 100 (wherein the back cover corresponds to a right side of the protective case as depicted in Fig. 1) can include the button cover 135, the first metal plate 140, the second metal plate 145, and the flap metal plate 150. Each of the first stand magnet 105, the second stand magnet 110, the closing magnet 115, the magnet shielding 120, the Hall sensor magnet 125, the flap magnet 130, the button cover 135, the first metal plate 140, the second metal plate 145, and the flap metal plate 150 can be positioned in a predetermined location on the protective case 100 such that each component can interact with either another component of the protective case 100 and/or a corresponding component of an electronic reading device when the protective case 100 is secured to the electronic reading device.

Fig. 2 depicts an exemplary overview of a system 200 including an electronic reading device 215 with a protective case (e.g., protective case 100) according to an embodiment. The protective case of the system 200 can include the first stand magnet 105, the second stand magnet 110, the closing magnet 115, the magnet shielding 120, the Hall sensor magnet 125, and the flap magnet 130, the button cover 135, the first metal plate 140, the second metal plate 145, and the flap metal plate 150 while an electronic reading device is secured within the back cover of the protective case 100. The electronic reading device 215 can include a device closing magnet 205 and a Hall sensor 210. The device closing magnet 205 can be positioned in a predetermined location within the electronic reading device 215 such that the device closing magnet 205 can be configured to magnetically connect with the closing magnet 115 when the front cover of the protective case 100 is in a closed position (e.g., the front cover of the protective case is covering the electronic reading device 215), for example. Similarly, the Hall sensor 210 can be positioned in a predetermined location within the electronic reading device 215 such that the Hall sensor magnet 125 interacts with the Hall sensor 210 when the protective case 100 is in the closed position.

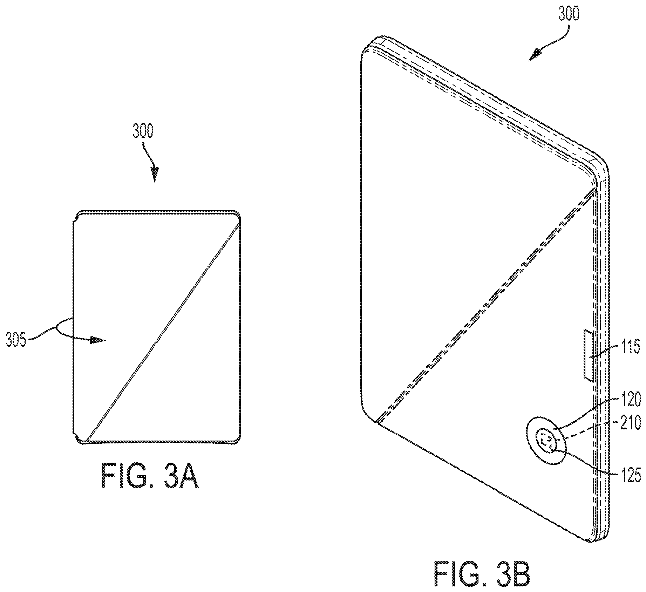

Fig. 3A depicts a front view of a system 300 including a protective case (e.g., protective case 100) in a closed position according to an embodiment. Arrow 305 can correspond to a closing direction of the protective case of the system 300 such that the closing direction corresponds to a front cover of the protective case covering a front of the electronic reading device (e.g., electronic reading device 215) while the electronic reading device 215 is secured in a back cover of the protective case.

Fig. 3B depicts a perspective view of the system 300 including the protective case (e.g., the protective case 100) in a closed position according to an embodiment. More specifically, the front cover of the protective case can cover the front of the electronic reading device 215 and be secured to the electronic reading device via a magnetic coupling of the closing magnet 115 and the device closing magnet 205 (as shown in Fig. 2). Similarly, the Hall sensor magnet 125 can be positioned in a predetermined location such that the Hall sensor magnet 125 interacts with the Hall sensor 210 (as shown in Fig. 2) when the protective case covers the front of the electronic reading device (e.g., wherein the front of the electronic reading device can correspond to a display of the electronic reading device). The predetermined positioning of the Hall sensor 210 and the Hall sensor magnet 125 allows the electronic reading device to enter a sleep mode. More specifically, the interaction between the Hall sensor 210 and the Hall sensor magnet 125 can be configured to cause the Hall sensor magnet 125 to trigger the Hall sensor 210 which can cause the electronic reading device to enter a sleep mode.

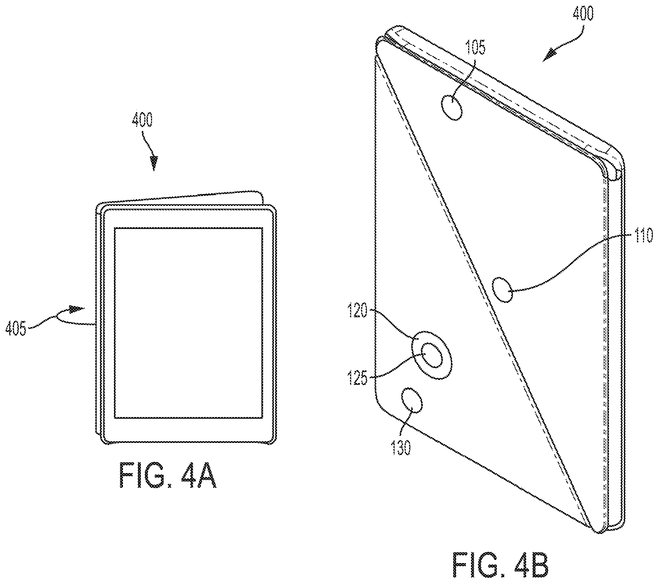

Fig. 4A depicts a front view of a system 400 including a protective case (e.g., the protective case 100) with a front cover of the protective case folded behind an electronic reading device (e.g., the electronic reading device 215) according to an embodiment. Arrow 405 can correspond to a direction indicating the front cover of the protective case being folded behind the electronic reading device.

Fig. 4B depicts a perspective view of a back of the system 400 wherein the front cover of the protective case (e.g., the protective case 100) is folded behind the electronic reading device (e.g., the electronic reading device 215) according to an embodiment. The first stand magnet 105, the second stand magnet 110, and the flap magnet 130 are each positioned in a predetermined location within the front cover of the protective case such that the predetermined location of the first stand magnet 105, the second stand magnet 110, and the flap magnet 130 corresponds to a predetermined position of each of the first metal plate 140, the second metal plate 145, and the flap metal plate 150. More specifically, each of the first stand magnet 105, the second stand magnet 110, and the flap magnet 130 and each of the first metal plate 140, the second metal plate 145, and the flap metal plate 150 is positioned such that the first stand magnet 105, the second stand magnet 110, and the flap magnet 130 are magnetically coupled to the first metal plate 140, the second metal plate 145, and the flap metal plate 150, respectively, when the front cover of the protective case is folded behind the electronic reading device as show in Fig. 4B. Additionally, the magnet shielding 120 can be positioned in the front cover of the protective case and between the Hall sensor magnet 125 and the electronic reading device. The magnet shielding 120 can be positioned between the Hall sensor magnet 125 and the electronic reading device to prevent the Hall sensor 125 from interacting with the Hall sensor 210 and causing the electronic reading device to enter a sleep mode at an unintended time. In other words, the magnet shielding 120 can prevent the Hall sensor magnet 125 from triggering the Hall sensor 210 when the front cover of the protective case is folded behind the electronic reading device.

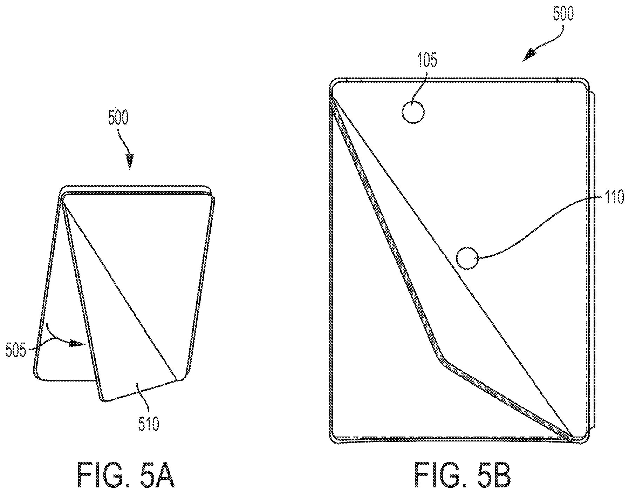

Fig. 5A depicts a perspective view of a system 500 including a protective case (e.g., the protective case 100) in a stand position according to an embodiment. In an embodiment, the front cover of the protective case may be folded behind an electronic reading device (e.g., the electronic reading device 215) while the electronic reading device is secured in a back cover of the protective case. While the front cover of the protective case is folded behind the electronic reading device, a portion of the front cover (e.g., portion 510) may be folded out as depicted by arrow 505 such that the portion 510 can be used as a stand, for example. When the protective case 100 is in the stand position, the device can be secured in a predetermined position, wherein the predetermined position can secure the device at a predetermined angle for convenient viewing and interaction of the device in the protective case, for example. Additionally, the device can be secured horizontally and/or vertically via the protective case 100 based on the stand position.

Fig. 5B depicts a rear view of the system 500 wherein the portion 510 of the front cover of the protective case can be in a stand position according to an embodiment. While the portion 510 is in the stand position, the first stand magnet 105 and the second stand magnet 110 can remain magnetically coupled to the first metal plate 140 and the second metal plate 145 disposed in the back cover of the protective case, thereby keeping the front cover of the protective case secured to the back cover of the protective case while the portion 510 is free to move into and/or return from the stand potion.

The protective case 100 has several advantages including precise position of the various magnets, metal plates, and shielding. For example, the functionality of the protective case can be significantly enhanced as a result of the position of the various components (wherein the components can include the first stand magnet 105, the second stand magnet 110, the closing magnet 115, the magnet shielding 120, the Hall sensor magnet 125, the flap magnet 130, the button cover 135, the first metal plate 140, the second metal plate 145, and the flap metal plate 150) because the protective case can be secured in a closed position (e.g., when the front cover of the protective case 100 covers a display of the electronic reading device 215) and/or a reading position (e.g., when the front cover of the protective case 100 is folded behind the electronic reading device 215). Additionally, even in the reading position, the portion 510 of the front cover of the protective case 100 can be folded into a stand position. Further, the magnet shielding 120 allows for the protective case 100 to be in the reading position while preventing any interaction between the Hall sensor magnet 125 and the Hall sensor 210 so the electronic reading device is not inadvertently put into a sleep mode.

## Claims

1. A protective case (100), comprising:
a back cover, wherein the back cover is configured to secure an electronic reading device (215), the back cover including
a plurality of metal plates, each of the plurality of metal plates disposed in a predetermined location, wherein the plurality of metal plates includes a first metal plate (140), a second metal plate (145), and a flap metal plate (150); and
a front cover, the front cover including
an upper portion, a flap portion (510), and a single folding hinge between the upper and the flap portion (510) extending diagonally across the front cover, and
a plurality of magnets, each of the plurality of magnets being disposed in a predetermined location and one or more of the plurality of magnets being positioned based on the location of one or more corresponding metal plates, wherein
the plurality of magnets includes a first stand magnet (105) positioned in the upper portion based on the first metal plate (140), a second stand magnet (110) positioned in the upper portion based on the second metal plate (145), and a flap magnet (130) positioned in the flap portion based on the flap metal plate (150), and
configured such that while the flap portion (510) is in a stand position, the first stand magnet (105) and the second stand magnet (145) remain magnetically coupled to the first metal plate (140) and the second metal plate (145) respectively, and
a Hall sensor magnet (125) located in the flap portion (510), wherein the Hall sensor magnet (125) is positioned on top of a magnet shielding (120), wherein the Hall sensor magnet (125) is positioned between the magnet shielding (120) and the back cover of the protective case (100) when the protective case (100) is in a closed position.

2. The protective case (100) of claim 1, wherein the first metal plate (140), the second metal plate (145), and the flap metal plate (150) are magnetically coupled to the first stand magnet (105), the second stand magnet (110), and the flap magnet (130), respectively, to secure the front cover of the protective case (100) to the back cover of the protective case (100) when the front cover of the protective case (100) is folded behind the electronic reading device (215).

3. The protective case (100) of claim 1, wherein the first metal plate (140) and the second metal plate (145) are magnetically coupled to the first stand magnet (105) and the second stand magnet (110), respectively, and a portion of the front cover of the protective case (100) is folded into a stand position.

4. The protective case (100) of claim 2, wherein the magnet shielding (120) is configured to prevent the Hall sensor magnet (125) from triggering a Hall sensor (210) disposed in the electronic reading device (215) when the front cover of the protective case (100) is folded behind the electronic reading device (215).

5. The protective case (100) of claim 1, wherein the plurality of magnets includes a first closing magnet (115) in a first predetermined location within the front cover, the first predetermined location of the closing magnet (115) being based on a second closing magnet (205) disposed in the electronic reading device (215), the predetermined location of the first closing magnet (115) being configured to magnetically couple to the second closing magnet (205) when the front cover is in a closed position, wherein the closed position corresponds to the front cover covering a display of the electronic reading device (215), wherein the first predetermined location is in the flap portion (510).

6. The protective case of claim 5, wherein the first predetermined location is on the edge of the flap portion (510).

7. The protective case (100) of claim 5 or 6, wherein the Hall sensor magnet (125) is positioned in a predetermined location of the front cover based on the Hall sensor (210) located in a predetermined position of the electronic reading device (215), the Hall sensor magnet (125) being configured to trigger the Hall sensor (210) when the front cover of the protective case (100) is secured to the electronic reading device (215) via the first closing magnet (115) and the second closing magnet (205), wherein the electronic reading device (215) is configured to enter a sleep mode in response to the Hall sensor magnet (125) triggering the Hall sensor (210).

8. A system, comprising:
an electronic reading device (215) including
a Hall sensor (210); and
the protective case (100) according to any of claims 1 to 7.

## Patentansprüche

1. Schutzgehäuse (100), umfassend:
eine Rückabdeckung, wobei die Rückabdeckung konfiguriert ist, um eine elektronische Lesevorrichtung (215) zu sichern, wobei die Rückabdeckung einschließt
eine Vielzahl von Metallplatten, wobei jede der Vielzahl von Metallplatten an einer vorbestimmten Lage angeordnet ist, wobei die Vielzahl von Metallplatten eine erste Metallplatte (140), eine zweite Metallplatte (145) und eine Klappenmetallplatte (150) einschließt; und
eine Frontabdeckung, wobei die Frontabdeckung einschließt
einen oberen Abschnitt, einen Klappenabschnitt (510) und ein einzelnes Faltgelenk zwischen dem oberen und dem Klappenabschnitt (510), das sich diagonal über die Frontabdeckung erstreckt, und
eine Vielzahl von Magneten, wobei jeder der Vielzahl von Magneten an einer vorbestimmten Lage angeordnet ist und einer oder mehrere der Vielzahl von Magneten basierend auf der Lage einer oder mehrerer entsprechender Metallplatten positioniert sind, wobei
die Vielzahl von Magneten einen ersten Standmagnet (105), der in dem oberen Abschnitt basierend auf der ersten Metallplatte (140) positioniert ist, einen zweiten Standmagnet (110), der in dem oberen Abschnitt basierend auf der zweiten Metallplatte (145) positioniert ist, und einen Klappenmagnet (130), der in dem Klappenabschnitt basierend auf der Klappenmetallplatte (150) positioniert ist, einschließt und
derart konfiguriert ist, dass während sich der Klappenabschnitt (510) in einer Standposition befindet, der erste Standmagnet (105) und der zweite Standmagnet (145) mit der ersten Metallplatte (140) beziehungsweise der zweiten Metallplatte (145) magnetisch gekoppelt bleiben, und
einen Hall-Sensormagnet (125), der in dem Klappenabschnitt (510) gelegen ist, wobei der Hall-Sensormagnet (125) oben auf einer Magnetabschirmung (120) positioniert ist, wobei der Hall-Sensormagnet (125) zwischen der Magnetabschirmung (120) und der Rückabdeckung des Schutzgehäuses (100) positioniert ist, wenn sich das Schutzgehäuse (100) in einer geschlossenen Position befindet.

2. Schutzgehäuse (100) nach Anspruch 1, wobei die erste Metallplatte (140), die zweite Metallplatte (145) und die Klappenmetallplatte (150) mit dem ersten Standmagnet (105), dem zweiten Standmagnet (110) beziehungsweise dem Klappenmagnet (130) magnetisch gekoppelt sind, um die Frontabdeckung des Schutzgehäuses (100) an der Rückabdeckung des Schutzgehäuses (100) zu sichern, wenn die Frontabdeckung des Schutzgehäuses (100) hinter der elektronischen Lesevorrichtung (215) gefaltet ist.

3. Schutzgehäuse (100) nach Anspruch 1, wobei die erste Metallplatte (140) und die zweite Metallplatte (145) mit dem ersten Standmagnet (105) beziehungsweise dem zweiten Standmagnet (110) magnetisch gekoppelt sind und ein Abschnitt der Frontabdeckung des Schutzgehäuses (100) in eine Standposition gefaltet ist.

4. Schutzgehäuse (100) nach Anspruch 2, wobei die Magnetabschirmung (120) konfiguriert ist, um zu verhindern, dass der Hall-Sensormagnet (125) einen Hall-Sensor (210), der in der elektronischen Lesevorrichtung (215) angeordnet ist, auslöst, wenn die Frontabdeckung des Schutzgehäuses (100) hinter der elektronischen Lesevorrichtung (215) gefaltet ist.

5. Schutzgehäuse (100) nach Anspruch 1, wobei die Vielzahl von Magneten einen ersten Schließmagnet (115) in einer ersten vorbestimmten Lage innerhalb der Frontabdeckung einschließt, wobei die erste vorbestimmte Lage des Schließmagnets (115) auf einem zweiten Schließmagnet (205), der in der elektronischen Lesevorrichtung (215) angeordnet ist, basiert, wobei die vorbestimmte Lage des ersten Schließmagnets (115) konfiguriert ist, um mit dem zweiten Schließmagnet (205) magnetisch zu koppeln, wenn sich die Frontabdeckung in einer geschlossenen Position befindet, wobei die geschlossene Position dem entspricht, dass die Frontabdeckung eine Anzeige der elektronischen Lesevorrichtung (215) abdeckt, wobei sich die erste vorbestimmte Lage in dem Klappenabschnitt (510) befindet.

6. Schutzgehäuse nach Anspruch 5, wobei sich die erste vorbestimmte Lage an dem Rand des Klappenabschnitts (510) befindet.

7. Schutzgehäuse (100) nach Anspruch 5 oder 6, wobei der Hall-Sensormagnet (125) an einer vorbestimmten Lage der Frontabdeckung basierend auf dem Hall-Sensor (210), der in einer vorbestimmten Position der elektronischen Lesevorrichtung (215) gelegen ist, positioniert ist, wobei der Hall-Sensormagnet (125) konfiguriert ist, um den Hall-Sensor (210) auszulösen, wenn die Frontabdeckung des Schutzgehäuses (100) über den ersten Schließmagnet (115) und den zweiten Schließmagnet (205) an der elektronischen Lesevorrichtung (215) gesichert ist, wobei die elektronische Lesevorrichtung (215) konfiguriert ist, um, als Reaktion darauf, dass der Hall-Sensormagnet (125) den Hall-Sensor (210) auslöst, in einen Ruhemodus einzutreten.

8. System, umfassend:
eine elektronische Lesevorrichtung (215), die einschließt
einen Hall-Sensor (210); und
das Schutzgehäuse (100) nach einem der Ansprüche 1 bis 7.

## Revendications

1. Étui de protection (100), comprenant :
un élément de couverture arrière, dans lequel l'élément de couverture arrière est conçu pour fixer un dispositif de lecture électronique (215), l'élément de couverture arrière comportant
une pluralité de plaques métalliques, chacune de la pluralité de plaques métalliques étant disposée dans un emplacement prédéterminé, dans lequel la pluralité de plaques métalliques comporte une première plaque métallique (140), une seconde plaque métallique (145) et une plaque métallique de rabat (150) ; et
un élément de couverture avant, l'élément de couverture avant comportant
une partie supérieure, une partie de rabat (510) et une charnière de pliage unique entre la partie supérieure et la partie de rabat (510) s'étendant en diagonale à travers l'élément de couverture avant, et
une pluralité d'aimants, chacun de la pluralité d'aimants étant disposé dans un emplacement prédéterminé et un ou plusieurs de la pluralité d'aimants étant positionnés sur la base de l'emplacement d'une ou de plusieurs plaques métalliques correspondantes, dans lequel
la pluralité d'aimants comporte un premier aimant de support (105) positionné dans la partie supérieure sur la base de la première plaque métallique (140), un second aimant de support (110) positionné dans la partie supérieure sur la base de la seconde plaque métallique (145), et un aimant de rabat (130) positionné dans la partie de rabat sur la base de la plaque métallique de rabat (150), et
conçu de telle sorte que lorsque la partie de rabat (510) est dans une position de support, le premier aimant de support (105) et le second aimant de support (145) restent accouplés magnétiquement à la première plaque métallique (140) et à la seconde plaque métallique (145) respectivement, et
un aimant de capteur à effet Hall (125) situé dans la partie de rabat (510), dans lequel l'aimant de capteur à effet Hall (125) est positionné au-dessus d'un blindage magnétique (120), dans lequel l'aimant de capteur à effet Hall (125) est positionné entre le blindage magnétique (120) et l'élément de couverture arrière de l'étui de protection (100) lorsque l'étui de protection (100) est dans une position fermée.

2. Étui de protection (100) selon la revendication 1, dans lequel la première plaque métallique (140), la seconde plaque métallique (145) et la plaque métallique de rabat (150) sont accouplées magnétiquement au premier aimant de support (105), au second aimant de support (110) et à l'aimant de rabat (130), respectivement, pour fixer l'élément de couverture avant du boîtier de protection (100) à l'élément de couverture arrière du boîtier de protection (100) lorsque l'élément de couverture avant du boîtier de protection (100) est plié derrière le dispositif de lecture électronique (215).

3. Étui de protection (100) selon la revendication 1, dans lequel la première plaque métallique (140) et la seconde plaque métallique (145) sont accouplées magnétiquement au premier aimant de support (105) et au second aimant de support (110), respectivement, et une partie de l'élément de couverture avant de l'étui de protection (100) est plié en position de support.

4. Étui de protection (100) selon la revendication 2, dans lequel le blindage magnétique (120) est configuré pour empêcher l'aimant de capteur à effet Hall (125) de déclencher un capteur à effet Hall (210) disposé dans le dispositif de lecture électronique (215) lorsque l'élément de couverture avant de l'étui de protection (100) est plié derrière le dispositif de lecture électronique (215).

5. Étui de protection (100) selon la revendication 1, dans lequel la pluralité d'aimants comporte un premier aimant de fermeture (115) dans un premier emplacement prédéterminé à l'intérieur de l'élément de couverture avant, le premier emplacement prédéterminé de l'aimant de fermeture (115) étant basé sur un second aimant de fermeture (205) disposé dans le dispositif de lecture électronique (215), l'emplacement prédéterminé du premier aimant de fermeture (115) étant conçu pour s'accoupler magnétiquement au second aimant de fermeture (205) lorsque l'élément de couverture avant est dans une position fermée, dans lequel la position fermée correspond à l'élément de couverture avant recouvrant un afficheur du dispositif de lecture électronique (215), dans lequel le premier emplacement prédéterminé est dans la partie de rabat (510).

6. Étui de protection selon la revendication 5, dans lequel le premier emplacement prédéterminé est sur le bord de la partie de rabat (510).

7. Étui de protection (100) selon la revendication 5 ou 6, dans lequel l'aimant de capteur à effet Hall (125) est positionné dans un emplacement prédéterminé de l'élément de couverture avant sur la base du capteur à effet Hall (210) situé dans une position prédéterminée du dispositif de lecture électronique (215), l'aimant de capteur à effet Hall (125) étant configuré pour déclencher le capteur à effet Hall (210) lorsque l'élément de couverture avant du boîtier de protection (100) est fixé au dispositif de lecture électronique (215) par l'intermédiaire du premier aimant de fermeture (115) et du second aimant de fermeture (205), dans lequel le dispositif de lecture électronique (215) est configuré pour entrer dans un mode de veille en réponse à l'aimant de capteur à effet Hall (125) déclenchant le capteur à effet Hall (210).

8. Système, comprenant :
un dispositif de lecture électronique (215) comportant
un capteur à effet Hall (210) ; et
l'étui de protection (100) selon l'une quelconque des revendications 1 à 7.
